# EUROPÄISCHE PATENTSCHRIFT

(11) **EP 1 112 575 B1**
(45) Veröffentlichungstag und Bekanntmachung des Hinweises auf die Patenterteilung: **18.12.2002**
(21) Anmeldenummer: 99942760.2
(22) Anmeldetag: 01.07.1999
(51) Int. Cl.: G11C 11/16, H01F 10/08

(54) **MAGNETORESISTIVES ELEMENT UND DESSEN VERWENDUNG ALS SPEICHERELEMENT IN EINER SPEICHERZELLENANORDNUNG**
MAGNETORESISTIVE ELEMENT AND USE OF SAME AS STORAGE ELEMENT IN A STORAGE SYSTEM
ELEMENT MAGNETORESISTANT ET SON UTILISATION COMME ELEMENT DE MEMORISATION DANS UN SYSTEME DE CELLULES DE MEMOIRE

(30) Priorität: 07.09.1998 DE 19840823
(43) Veröffentlichungstag der Anmeldung: 04.07.2001
(73) Patentinhaber: Infineon Technologies AG, 81669 München (DE)
(72) Erfinder: SCHWARZL, Siegfried, D-85579 Neubiberg (DE)
(74) Vertreter: Hermann, Uwe, Dipl.-Ing.
(86) Internationale Anmeldenummer: DE9901942
(87) Internationale Veröffentlichungsnummer: WO00014748

(56) Entgegenhaltungen:
- US-A- 4 945 397
- US-A- 5 667 879

## Beschreibung

Magnetoresistive Elemente, auch Magnetowiderstandselemente genannt, werden zunehmend als Sensorelemente oder als Speicherelemente für Speicherzellenanordnungen, sogenannte MRAMs, verwendet (siehe S. Mengel, Technologieanalyse Magnetismus Band 2, XMR-Technologien, Herausgeber VDI Technologiezentrum Physikalische Technologien, August 1997). Als magnetoresistives Element wird in der Fachwelt eine Struktur verstanden, die mindestens zwei ferromagnetische Schichten und eine dazwischen angeordnete nichtmagnetische Schicht aufweist. Je nach Aufbau der Schichtstruktur wird dabei unterschieden zwischen GMR-Element, TMR-Element und CMR-Element.

Der Begriff GMR-Element wird in der Fachwelt für Schichtstrukturen verwendet, die mindestens zwei ferromagnetische Schichten und eine dazwischen angeordnete nichtmagnetische, leitende Schicht aufweisen und den sogenannten GMR-(giant magnetoresistance)Effekt zeigen. Unter dem GMR-Effekt wird die Tatsache verstanden, daß der elektrische Widerstand des GMR-Elementes abhängig davon ist, ob die Magnetisierungen in den beiden ferromagnetischen Schichten parallel oder antiparallel ausgerichtet sind. Der GMR-Effekt ist im Vergleich zum sogenannten AMR-(anisotropic magnetoresistance)Effekt groß. Als AMR-Effekt wird die Tatsache verstanden, daß der Widerstand in magnetisierten Leitern parallel und senkrecht zur Magnetisierungsrichtung verschieden ist. Bei dem AMR-Effekt handelt es sich um einen Volumeneffekt, der in ferromagnetischen Einfachschichten auftritt.

Der Begriff TMR-Element wird in der Fachwelt für Tunneling Magnetoresistance Schichtstrukturen verwendet, die mindestens zwei ferromagnetische Schichten und eine dazwischen angeordnete isolierende, nichtmagnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nichtmagnetische Schicht bewirkt wird. Auch in diesem Fall ist der elektrische Widerstand des TMR-Elementes abhängig davon, ob die Magnetisierungen in den beiden ferromagnetischen Schichten parallel oder antiparallel ausgerichtet sind. Die relative Widerstandsänderung beträgt dabei etwa 6 Prozent bis ca. 30 Prozent.

Ein weiterer Magnetowiderstandseffekt, der wegen seiner Größe (relative Widerstandsänderung von 100 bis 400 Prozent bei Raumtemperatur) Collosal Magnetoresistance-Effekt (CMR-Effekt) genannt wird, erfordert wegen seiner hohen Koezitivkräfte ein hohes Magnetfeld zum Umschalten zwischen den Magnetisierungszuständen.

Es ist vorgeschlagen worden, (siehe zum Beispiel S. Tehrani et al, IEDM 96-193 und D. D. Tang et al, IEDM 95-997) GMR-Elemente als Speicherelemente in einer Speicherzellenanordnung zu verwenden. Die Speicherelemente werden über Leseleitungen in Reihe verschaltet. Quer dazu verlaufen Wortleitungen, die sowohl gegenüber den Leseleitungen als auch gegenüber den Speicherelementen isoliert sind. An die Wortleitungen angelegte Signale verursachen durch den in der Wortleitung fließenden Strom ein Magnetfeld, das bei hinreichender Stärke die darunter befindlichen Speicherelemente beeinflußt. Zum Einschreiben von Information werden X/Y-Leitungen verwendet, die sich oberhalb der zu beschreibenden Speicherzelle kreuzen. Sie werden mit Signalen beaufschlagt, die am Kreuzungspunkt ein für die Ummagnetisierung ausreichendes magnetisches Feld verursachen. Dabei wird die Magnetisierungsrichtung in der einen der beiden ferromagnetischen Schichten umgeschaltet. Die Magnetisierungsrichtung in der anderen der beiden ferromagnetischen Schichten bleibt dagegen unverändert. Das Festhalten der Magnetisierungsrichtung in der zuletzt genannten ferromagnetischen Schicht erfolgt durch eine benachbarte antiferromagnetische Schicht, die die Magnetisierungsrichtung festhält, oder dadurch, daß die Schaltschwelle für diese ferromagnetische Schicht durch anderes Material oder andere Dimensionierung, zum Beispiel Schichtdicke im Vergleich zu der zuerst genannten ferromagnetischen Schicht vergrößert wird.

In US 5 541 868 sind ringförmige Speicherelemente vorgeschlagen worden, die auf dem GMR-Effekt beruhen. Ein Speicherelement umfaßt einen Stapel, der mindestens zwei ringförmige ferromagnetische Schichtelemente und ein nichtmagnetisches leitendes Schichtelement, das dazwischen angeordnet ist, aufweist. Die ferromagnetischen Schichtelemente unterscheiden sich in ihrer Materialzusammensetzung. Eines der ferromagnetischen Schichtelemente ist magnetisch hart, das andere magnetisch weicher. Zum Einschreiben der Information wird die Magnetisierungsrichtung in dem magnetisch weicheren Schichtelement umgeschaltet, während die Magnetisierungsrichtung in dem magnetisch härteren Schichtelement erhalten bleibt.

Im Hinblick auf einen großtechnischen Einsatz von magnetoresistiven Elementen z. B. als integrierte magnetoresistive Speicherzellenanordnung (sogenanntes MRAM) oder als integrierte Sensoranordnung ist die Integration magnetoresistiver Elemente in eine Halbleiterprozeßtechnologie erfoderlich. In der Halbleiterprozeßtechnologie treten insbesondere bei der Fertigstellung der Halbleiteranordnungen im sogenannten Backend-Prozeß auf Scheibenebene, auch BEOL (Back end of line) genannt, Temperaturen bis mindestens etwa 450°C auf (siehe zum Beispiel D. Widmann et al, Technologie integrierter Schaltungen, Springer Verlag 1996, S. 58) , denen die magnetoresitiven Elemente ebenfalls ausgesetzt werden. In diesem Temperaturbereich ist aufgrund der Diffusionsbeweglichkeit der in magnetoresistiven Schichtsystemen enthaltene Elemente, insbesondere Fe, Co, Ni, Cu etc., mit einer Diffusion zu rechnen, die die Eigenschaften der ferromagnetischen Schichtelemente so verändert, daß magnetoreaistive Elemente mit ferromagnetischen Schichtelementen aus unterschiedlichen Materialzusammensetzungen nicht mehr funktionsfähig sind. Aufgrund der befürchteten Diffusion kommt es zu einer Veränderung der Materialzusammensetzung in den Grenzflächenzonen, die den spinabhängigen Elektronentransport, auf dem die Magnetowiderstandseffekte in diesen Elementen beruhen, beeinträchtigt. Es muß daher erwartet werden, daß bereits geringe diffusionsbedingte Materialwanderungen mit einer Reichweite im Bereich von 1 bis 5 nm über diese Grenzflächen hinweg zu erheblichen Veränderungen der magnetischen und elektrischen Eigenschaften führen. Bereits Diffusionslängen von einigen Nanometern können völlig veränderte Grenzflächeneigenschaften verursachen, die zu Eigenschaftsdriften oder sogar zum Totalausfall der magnetoresistiven Elemente führen (siehe I. Kaur, W. Gust, 'Fundamentals of Grain an Interphase Boundary Diffusion', Ziegler Press, Stuttgart (1989), Seiten 16 bis 26, 287, 316 bis 318 und I. Kaur, W. Gust, L. Kozma, Handbook of Grain and Interphase Boundary Data, Volume 1 and 2, Ziegler Press, Stuttgart (1989), Seiten 8 bis 13,220 bis 224, 403, 515, 528, 530, 776, 952 bis 953, 966 bis 998).

In der US 4,945,397 ist ein magnetoresistives Element gemäß des Oberbegriffs des Anspruchs 1 beschrieben, bei dem eine weitere nichtmagnetische Schicht als Deckschicht vorhanden ist. Als Materialien für die ferromagnetischen Schichten sind Verbindungen oder Mischungen von Ni, Fe und Co, als Materialien für die nichtmagnetischen Schichten TaNₓ angegeben.

Das Problem, magnetoresistive Elemente in eine Halbleiterprozeßtechnik zu integrieren und die dabei möglicherweise auftretende Schwierigkeiten sind in der Literatur bisher nicht behandelt worden.

Der Erfindung liegt das Problem zugrunde, ein magnetoresistives Element anzugeben, das im Rahmen einer Halbleiterprozeßtechnik herstellbar ist.

Dieses Problem wird erfindungsgemäß gelöst durch ein magnetoresistives Element gemäß Anspruch 1. Weitere Ausgestaltungen der Erfindung gehen aus den übrigen Ansprüchen hervor.

Das magnetoresistive Element weist ein erstes ferromagnetisches Schichtelement, ein nichtmagnetisches Schichtelement und ein zweites ferromagnetisches Schichtelement auf, wobei das nichtmagnetische Schichtelement zwischen dem ersten ferromagnetischen Schichtelement und dem zweiten ferromagnetischen Schichtelement angeordnet ist. Das nichtmagnetische Schichtelement weist eine Diffusionsbarrierewirkung in einem Temperaturbereich auf, der bei der Herstellung des magnetoresistiven Elementes erforderlich ist. Temperaturen aus diesem Temperaturbereich ist das magnetoresistive Element bei der Herstellung ausgesetzt.

In dem erfindungsgemäßen magnetoresistiven Element wird eine Veränderung der Eigenschaften der ferromagnetischen Schichtelemente aufgrund von im Prozeß auftretenden Temperaturbelastungen dadurch vermieden, daß das nichtmagnetische Schichtelement aus einem Material mit Diffusionsbarrierewirkung gebildet wird und selbst nicht in die benachbarten ferromagnetischen Schichtelemente eindiffundiert.

Vorzugsweise wird das nichtmagnetische Schichtelement aus einem Material gebildet, das im Temperaturbereich von 20°C bis 450°C die Diffusionsbarrierewirkung aufweist. Damit wird sichergestellt, daß bei den in einer Siliziumprozeßtechnik bei der Fertigstellung einer das magnetoresistive Element umfassenden Anordnung auftretende Temperaturbelastungen, die insbesondere bei der Prozessierung von Metallisierungssystemen bis zu 450°C betragen, keine Diffusionen zwischen dem ersten ferromagnetischen Schichtelement, dem zweiten ferromagnetischen Schichtelement und dem nichtmagnetischen Schichtelement hervorrufen.

Es liegt im Rahmen der Erfindung, daß das nichtmagnetische Schichtelement mindestens eines der Elemente Ti, Ta, W, Nb, Mo, mit oder ohne Zusätze von N, Si oder B enthält.

Die Dicke des nichtmagnetischen Schichtelementes liegt vorzugsweise zwischen 2 nm und 4 nm.

Das erste ferromagnetische Schichtelement und das zweite Schichtelement enthält jeweils vorzugsweise mindestens eines der Elemente Fe, Ni, Co, Gd, Dy. Die Dicken des ersten und zweiten ferromagnetischen Schichtelementes liegen vorzugsweise zwischen 2 nm und 20 nm. Die Querschnitte der ferromagnetischen Schichtelemente sind parallel zur Schichtebene beliebig, sie können insbesondere rund, oval, eckig oder ringförmig sein.

Das erste ferromagnetische Schichtelement und das zweite ferromagnetische Schichteleket unterscheiden sich bezüglich ihrer Materialzusammensetzung und/oder ihrer Dimensionen.

Das magnetoresistive Element ist sowohl als Sensorelement als auch als Speicherelement einer Speicherzellenanordnung geeignet.

Im folgenden werden Ausführungsbeispiele der Erfindung anhand der Figuren näher erläutert. Die Darstellungen in den Figuren sind nicht maßstabsgerecht.
- Figur 1: zeigt einen Schnitt durch ein magnetoresistives Element.
- Figur 2: zeigt eine Aufsicht auf eine Speicherzellenanordnung.

Ein magnetoresistives Element weist ein erstes ferromagnetisches Schichtelement 1 aus Fe, Ni, Co, Gd, Dy oder Legierungen davon, ein nichtmagnetisches Schichtelement 3 aus Ti, Ta, W, Nb, Mo mit oder ohne Zusätzen von N, Si oder B und ein zweites ferromagnetisches Schichtelement 2 aus Fe, Ni, Co, Gd, Ry oder Legierungen davon auf. Das erste ferromagnetische Schichtelement 1 weist einen im wesentlichen rechtwinkligen Querschnitt mit Abmessungen von ca. 100 nm x 150 nm und eine Dicke von ca. 20 nm auf. Das zweite ferromagnetische Schichtelement weist einen im wesentlichen rechtwinkligen Querschnitt mit Abmessungen von 100 nm x 150 nm und eine Dicke von ca. 5 nm auf. Das nichtmagnetische Schichtelement 3 weist ebenfalls einen im wesentlichen rechtwinkligen Querschnitt mit Abmessungen von 100 nm x 150 nm und eine Dicke von 2 bis 4 nm auf. In diesem magnetoresistiven Element wird durch das nichtmagnetische Schichtelement 3 aus Ti, Ta, W, Nb, Mo mit oder ohne Zusätzen von N, Si oder B eine Diffusion bis zu einer Temperatur von 450°C wirksam verhindert.

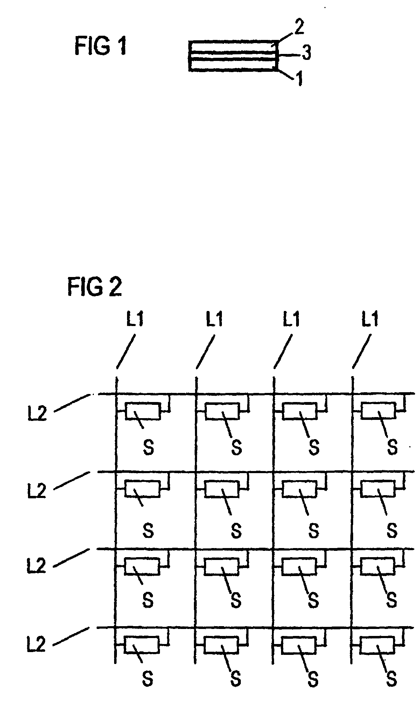

Zum Aufbau einer Speicherzellenanordnung, die als Speicherelemente S magnetoresistive Elemente aufweist, die wie anhand von Figur 1 geschildert aufgebaut sind, werden die Speicherelemente S rasterförmig angeordnet. Jedes Speicherelement S ist dabei zwischen eine erste Leitung L1 und eine zweite Leitung L2 geschaltet. Die ersten Leitungen L1 verlaufen untereinander parallel und kreuzen die zweiten Leitungen L2, die untereinander ebenfalls parallel verlaufen (siehe Figur 2). Zum Schreiben eines Speicherelementes S fließt über eine zugehörige Leitung L1 und eine zugehörige zweite Leitung L2 jeweils ein solcher Strom, daß am Kreuzungspunkt der ersten Leitung L1 und der zweiten Leitung L2, an dem das Speicherelement angeordnet ist, ein ausreichendes Magnetfeld entsteht, um die Magnetisierungsrichtung des zweiten ferromagnetischen Schichtelementes umzuschalten. Das am jeweiligen Kreuzungspunkt wirksame Magnetfeld ist dabei eine Überlagerung aus dem durch den Stromfluß in der ersten Leitung L1 induzierten Magnetfeldes und des durch den Stromfluß in der zweiten Leitung L2 induzierten Magnetfeldes.

In der Speicherzellenanordnung wird dem Widerstandswert der magnetoresistiven Elemente, der der parallelen Ausrichtung der Magnetisierungsrichtung im ersten ferromagnetischen Schichtelement zu der im zweiten ferromagnetischen Schichtelement entspricht ein erster logischer Wert, dem Widerstandswert, der der antiparallelen Ausrichtung der Magnetisierungsrichtung in dem ersten ferromagnetischen Schichtelement zu dem des zweiten ferromagnetischen Schichtelement entspricht, ein zweiter logischer Wert zugeordnet.

## Patentansprüche

1. Magnetoresistives Element,
mit einem ersten ferromagnetischen Schichtelement (1), einem nichtmagnetischen Schichtelement (3) und einem zweiten ferromagnetischen Schichtelement (2),
bei dem das nichtmagnetische Schichtelement (3) zwischen dem ersten ferromagnetischen Schichtelement (1) und dem zweiten ferromagnetischen Schichtelement (2) angeordnet ist,
**dadurch gekennzeichnet, dass**
das nichtmagnetische Schichtelement (3)
mindestens eines der Elemente Ti, W, Mo,
ein Nitrid dieser Elemente,
ein Silizid der Elemente Ti, Ta, W, Mo,
ein Borid dieser Elemente oder
eine Legierung aus mindestens zwei dieser Elemente enthält.

2. Magnetoresistives Element nach Anspruch 1,
bei dem sich das erste ferromagnetische Schichtelement (1) und das zweite ferromagnetische Schichtelement (2) bezüglich ihrer Materialzusammensetzung unterscheiden.

3. Magnetoresistives Element nach Anspruch 1 oder 2,
bei dem das erste ferromagnetische Schichtelement (1) und das zweite ferromagnetische Schichtelement (2) jeweils mindestens eines der Elemente Fe, Ni, Co, Gd, Dy enthält.

4. Verwendung eines magnetoresistiven Elementes nach einem der Ansprüche 1 bis 3 als Speicherelement in einer Speicherzellenanordnung.

## Claims

1. Magnetoresistive element,
having a first ferromagnetic layer element (1), a nonmagnetic layer element (3) and a second ferromagnetic layer element (2), in which the nonmagnetic layer element (3) is arranged between the first ferromagnetic layer element (1) and the second ferromagnetic layer element (2),
**characterized in that**
the nonmagnetic layer element (3) contains
at least one of the elements Ti, W, Mo,
a nitride of these elements,
a silicide of the elements Ti, Ta, W, Mo,
a boride of these elements or
an alloy comprising at least two of these elements.

2. Magnetoresistive element according to Claim 1,
in which the first ferromagnetic layer element (1) and the second ferromagnetic layer element (2) differ with regard to their material composition.

3. Magnetoresistive element according to Claim 1 or 2,
in which the first ferromagnetic layer element (1) and the second ferromagnetic layer element (2) in each case contain at least one of the elements Fe, Ni, Co, Gd, Dy.

4. Use of a magnetoresistive element according to one of Claims 1 to 3 as memory element in a memory cell arrangement.

## Revendications

1. Elément magnétorésistant
comprenant un premier élément (1) ferromagnétique sous forme de couche, un élément (3) amagnétique sous forme de couche et un deuxième élément (2) ferromagnétique sous forme de couche
dans lequel l'élément (3) amagnétique sous forme de couche est interposé entre le premier élément (1) ferromagnétique sous forme de couche et le deuxième élément (2) ferromagnétique sous forme de couche
**caractérisé en ce que** l'élément (3) amagnétique sous forme de couche comprend au moins l'un des éléments Ti, W, Mo,
un nitrure de ces éléments,
un siliciure des éléments Ti, Ta, W, Mo,
un borure de ces éléments ou
un alliage d'au moins deux de ces éléments.

2. Elément magnétorésistant suivant la revendication 1,
dans lequel le premier élément (1) ferromagnétique sous forme de couche et le deuxième élément (2) ferromagnétique sous forme de couche se distinguent du point de vue de leur composition de matière.

3. Elément magnétorésistant suivant la revendication 1 ou 2,
dans lequel le premier élément (1) ferromagnétique sous forme de couche et le deuxième élément (2) ferromagnétique sous forme de couche, comprennent respectivement au moins l'un des éléments Fe, Ni, Co, Gd, Dy.

4. Utilisation d'un élément magnétorésistant suivant l'une quelconque des revendications 1 à 3, comme élément de mémorisation dans un dispositif de cellules de mémoire.
